# EUROPEAN PATENT SPECIFICATION

(11) **EP 4 078 259 B1**
(45) Date of publication and mention of the grant of the patent: **17.04.2024**
(21) Application number: 20829387.8
(22) Date of filing: 18.12.2020
(51) Int. Cl.: G02B 6/42, H01S 5/022

(54) **OPTICAL COMPONENT**
OPTISCHE KOMPONENTE
COMPOSANT OPTIQUE

(30) Priority: 19.12.2019 US 201962950485 P
(43) Date of publication of application: 26.10.2022
(73) Proprietor: ams Sensors Singapore Pte. Ltd., Singapore 569877 (SG)
(72) Inventor: PARRA, Edgar A. Flores, 5656 AE Eindhoven (NL)
(74) Representative: OSRAM GmbH - GC IP
(86) International application number: PCT/SG2020/050763
(87) International publication number: WO 2021/126088

(56) References cited:
- WO-A2-02/093696
- US-A1- 2018 208 459
- US-A1- 2019 036 297

## Description

### Technical Field of the Disclosure

This disclosure relates to compact optoelectronic modules.

### Background of the Disclosure

Various consumer electronic products and other devices include a packaged light emitter or detector modules designed for precision light projection or detection applications. The spatial dimensions of such modules are generally extremely small, thereby enabling their incorporation into portable devices. One technology that is suitable for miniature illuminators is high power vertical cavity surface emitting laser (VCSEL) devices and array devices.

The optical output power of a bare VCSEL typically can, in some cases, be so high that it may cause damage to a person's eye or skin in the event the quality of the optical component is compromised. Thus, it is important to ensure that the high power laser illuminators meet laser safety regulations when in operation. For example, the illuminator may be part of an assembly that, under normal operating conditions, maintains eye-safe operation by preventing a person from getting too close to the illuminator. However, in some cases, damage (e.g., cracks) to the optical structure that modifies the output beam for safe operation, or the presence of moisture or chemical contamination on the optical structure, may result in safety hazards. Likewise, if the optical structure were to fall off or be removed, safety could be compromised.

US 2018/0208459 A1 discloses an interdigital capacitor with conductor lines used for applying a porous matrix structure.

It is therefore an aim of the present disclosure to provide an optoelectronic module that addresses one or more of the problems described above or at least provides a useful alternative.

### Summary

The above problems is sought to be overcome by enabling detection of damage or the presence of moisture or chemical contamination on the optical structure. The arrangement does so without compromising the optical performance of the module and enabling straightforward manufacture.

According to an embodiment there is provided an optical assembly, the optical assembly comprising an interdigital capacitor with an electrically conductive trace, one or more electrical contacts in electrical connection with the conductive trace and an insulating layer covering at least a portion of the interdigital capacitor. The one or more electrical contacts and a portion of the insulating layer are configured to receive conductive adhesive. The optical assembly further comprises a metallic layer positioned between the conductive trace and the portion of the insulating layer configured to receive the conductive adhesive.

In one embodiment the optical assembly further comprises circuitry configured to detect a change in capacitance of the interdigital capacitor.

In one embodiment the interdigital capacitor comprises indium titanium oxide.

In one embodiment the metallic layer is transparent.

In one embodiment the metallic layer comprises indium titanium oxide.

In one embodiment the metallic layer is embedded in the insulating layer.

In one embodiment the metallic layer is electrically floating, i.e. no specific potential is applied to the metallic layer by circuitry and instead the potential of the metallic layer is allowed to fluctuate or `float' under the influence of the electric fields the metallic layer is exposed to.

In one embodiment the metallic layer is adjacent to one or more edges of the optical assembly.

In one embodiment the conductive adhesive comprises a layer of conductive adhesive with a first dimension in a plane parallel to the first surface of the optical assembly ranging from 100µm to 600µm.

According to another embodiment there is provided an optical module comprising an optical assembly, the optical assembly comprising a interdigital capacitor with an electrically conductive trace, one or more electrical contacts in electrical connection with the conductive trace, an insulating layer covering at least a portion of the interdigital capacitor, circuitry operable to detect a change in capacitance of the interdigital capacitor and conductive adhesive disposed on at least a portion of the one or more electrical contacts and a portion of the insulating layer and configured to maintain the circuitry and one or more electrical contacts in electrical connection. The optical assembly further comprises a metallic layer positioned between the conductive trace and the portion of the insulating layer on which the conductive adhesive is disposed.

Finally, the present optical assembly disclosed herein utilises a novel approach in that a metal shielding layer is provided to shield a conductive trace for detecting changes in the optical assembly from the effect of conductive adhesive on its capacitance.

### Brief Description of the Preferred Embodiments

Some embodiments of the disclosure will now be described by way of example only and with reference to the accompanying drawings, in which:
Fig. 1 shows an optoelectronic module comprising a light emitting element and eye-safety capability;
Fig. 2 shows a component prior to the application of a conductive adhesive;
Fig.3 shows the component shown in Fig. 2 after the application of a conductive adhesive;
Fig. 4 illustrates an arrangement comprising a shielding layer;
Fig. 5A shows an embodiment prior to the application of a conductive adhesive for contacting a terminal of one electrode of an interdigital capacitor;
Fig. 5B shows an embodiment after the application of a conductive adhesive contacting the terminal of the one electrode of an interdigital capacitor;
Fig. 5C shows an embodiment prior to the application of a conductive adhesive for contacting a terminal of a second electrode of an interdigital capacitor;
Fig. 5D shows an embodiment after the application of a conductive adhesive contacting the terminal of the second electrode of an interdigital capacitor;
Fig. 6 illustrates electric fields created in the absence of a shielding layer;
Fig. 7A shows electric fields created in the absence of a shielding layer but presence of conductive adhesive;
Fig. 7B illustrates changes in capacitance of the interdigital capacitor of Fig. 7A with changes in the width of adhesive applied;
Fig. 8A shows electric fields created in the presence of a shielding layer and conductive adhesive;
Fig. 8B illustrates changes in capacitance of the interdigital capacitor of Fig. 8A with changes in the width of adhesive applied;
Fig. 9A is an exploded schematic view of the electric potentials conductive adhesive present but shielding layer absent;
Fig. 9B shows the potential with an adhesive trace 600 µm wide in the presence of a shielding layer;
Fig. 9C shows the potential with an adhesive trace 200 µm wide in the presence of a shielding layer;
Fig. 9D shows the potential of the adhesive traces directly above the shielding layer for a glue width of 100um; and
Fig. 9E shows the potential of the adhesive traces directly above the shielding layer for a glue width of 300um.

### Detailed Description of the Preferred Embodiments

Generally speaking, the disclosure provides an optoelectronic module solution which provides high sensitivity to damage to the optical component without compromising optical performance.

Some examples of the solution are given in the accompanying figures.

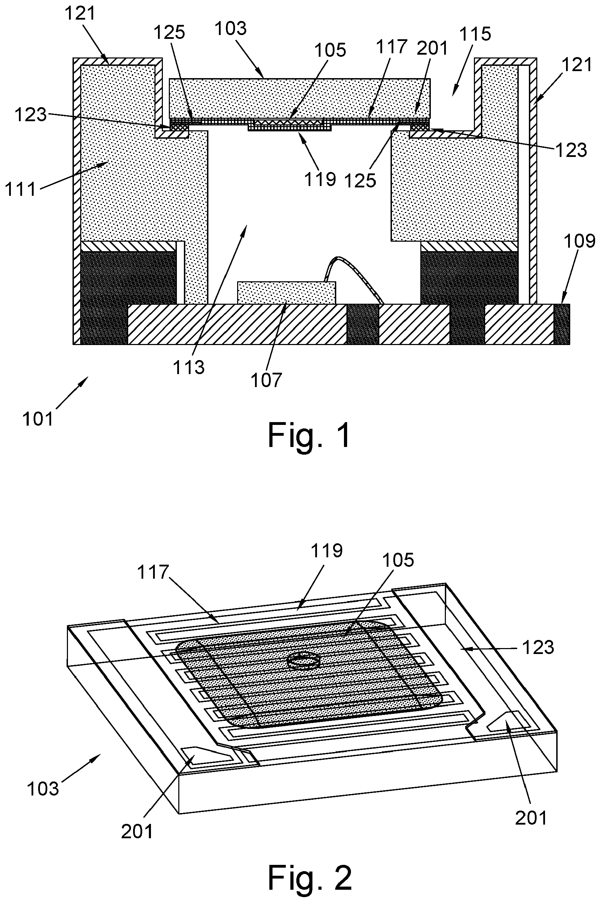

An optoelectronic module 101 comprising a light emitting element and eye-safety capability according to an embodiment is shown in Fig. 1. The outside dimensions of thei module may be in the range of 2000 µ*m* x1700 µ*m* x700 µ*m* and 5000 µ*m* x4000 µ*m* x3000 µ*m*. In this embodiment, the optoelectronic module comprises a glass 103 with an optical component 105 disposed over a light source 107. The optical component 105 is positioned so as to intersect the path of light beam(s) produced by the light source 107. In the discussion below it is assumed that the light source 107 is a vertical cavity surface emitting laser (VCSEL). However, other types of optical emitters or even detectors may be employed in the optoelectronic module 101 according to embodiments. Examples include an array of VCSELs, one or more light emitting diodes (LEDs), infra-red (IR) LEDs, organic LEDs (OLEDs), infra-red (IR) lasers, or edge-emitting laser diodes. In an embodiment, the light source 107 is operable to emit light at a particular wavelength or within a relatively narrow wavelength range (e.g., infra-red). In certain embodiments, the light source 107 is operable to generate coherent light.

The VCSEL 107 is electrically connected to leadframe 109 via which power is supplied to the VSCEL 107. In an embodiment, power to the VCSEL 107 may be controlled by a current driver controller or other electronic control unit (ECU) (not shown). The controller can reside, for example, in a host device (e.g., smartphone) into which the module 101 is integrated.

In the discussion below it is assumed that the optical component 105 is a micro lens array (MLA). However, other optical assemblies such as an optical diffuser, a lens, a refractive or diffractive optical element, a diffuser, a spectral filter, a polarizing filter, and/or some other optical structure operable to modify the optical characteristics of the output beam of the light source, which is incident on the optical assembly may be employed in place of the MLA according to embodiments.

The glass 103 is held in position above the VCSEL 107 by a spacer 111 according to an embodiment. The spacer has a cavity 113 in which the VCSEL 107 is mounted. The spacer 111 can be composed, for example, of an electrically insulating material, such as a molded epoxy (e.g., a liquid crystal polymer-based material). In the embodiment of Fig. 1, the MLA glass 103 resides in a socket 115 of the spacer 111. However, in other embodiments, there may be no socket and the glass 103 may rest on the uppermost surface of the spacer.

In this embodiment, the MLA 105 is positioned on the inner surface 117 of the glass 103, facing the VCSEL 107. In other embodiments, the MLA 105 may be positioned on the outer surface of the glass 103.

An electrically conductive trace 119 is disposed on the surface of the glass 103, including over the portion of the glass comprising the MLA 105. This is shown more clearly in Fig. 2 which shows a detailed perspective view of the glass 103. In this embodiment, the MLA 105 is positioned towards the centre of the glass 103. An electrical trace 119 is disposed on the surface 117 of the glass 103. In this embodiment, the electrically conductive trace 119 is an interdigital capacitor. In some cases, the trace 119 is composed of a material (e.g., indium tin oxide (ITO)) that is substantially transparent to the wavelength of light produced by the VCSEL 107 (e.g., infra-red). Such electrically conductive structures thus can at least partially overlap a footprint of the optical beam emitted by the VCSEL 107. In other instances, the electrically conductive structure can be composed of a material (e.g., chrome) that is substantially opaque to the wavelength of light produced by the light emitter 107. In such cases, the electrically conductive trace 119 preferably does not overlap the footprint of an optical beam emitted by the VCSEL 107.

The trace 119 is electrically connected to electrical contacts 201 on the surface 117 of the glass 103. The electrical contacts may comprise conductive pads composed of gold or silver or another suitable conducting material. In some instances, the trace 119 is covered with an insulating layer 301. In an embodiment the insulating layer may comprise SiO₂ or another suitable insulating material. If an insulating layer is employed, openings in the insulating material are provided for the electrical contacts 201.

The module 101 comprises electrically conductive leads 121 which extend from the socket 115 of the spacer 111 and down to the leadframe 109. In other embodiments, leads may be integrated into the walls of the spacer 111 or otherwise arranged to provide an electrical connection from the portion of the spacer on which the glass 103 is mounted to the leadframe 109. In an embodiment, the trace 119 is electrically connected to the leads 121 via contacts 201 with conductive adhesive 123. In an embodiment, the conductive adhesive 123 is silver epoxy. In other embodiments, another suitable conductive adhesive may be employed. Thus, the trace 119 is connected to the leadframe 109 via contacts 201, conductive adhesive 123 and leads 121.

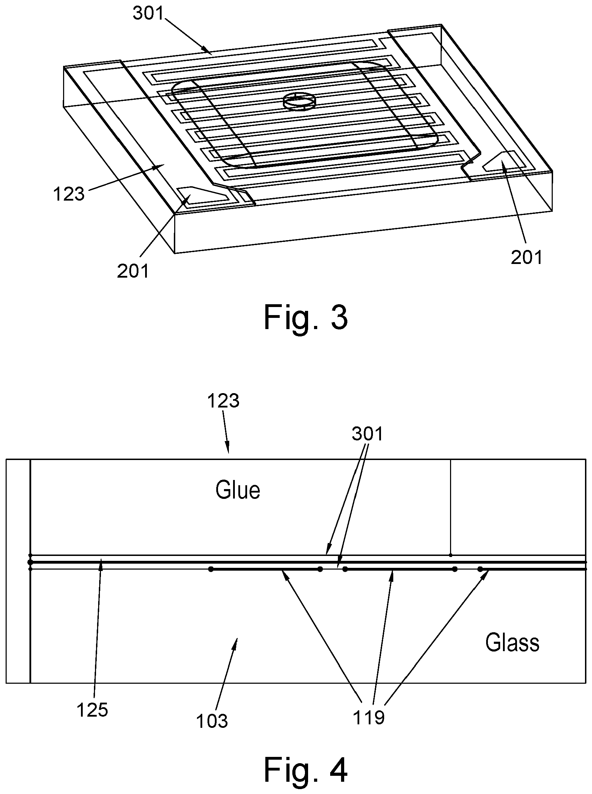

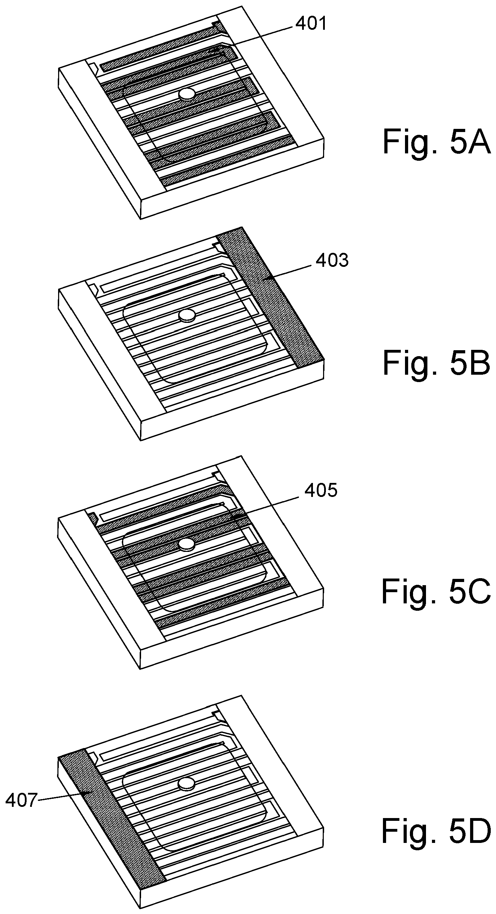

In an embodiment, the conductive adhesive is deposited on top of the insulating layer of the glass 103 as a strip running down the side of the MLA glass and interfacing with electrical contacts 201. This is shown in Fig. 2 and 3 and, in detail, in Fig. 5A to 5D. Providing the conductive glue as a strip may advantageously enable straightforward application of the glue to the MLA glass, thereby facilitating manufacture. Further, when applied as a strip, the conductive glue may provide mechanical adhesion to the spacer or other elements of the module packaging, in addition to providing electrical connection. This mechanical adhesion via the conductive adhesive 123 may be provided instead of, or in addition to use of another adhesive with only mechanical properties within the package. In other embodiments, the conductive adhesive may take other suitable forms, such as a dot or partial strip. The form and position of the conductive adhesive 123 may be selected according to the design of the spacer or positioning of the leads 121 and/or electrical contacts 201 according to embodiments.

In an embodiment, the strip of conductive glue on one side of the glass 3 is connected to one of the capacitor terminals 401 and assigned 1V potential via the leads 121. The second strip of conductive glue 407 on the opposite side of the glass is connected to the other terminal 405 in the trace 119 and connected to ground as shown in Figure 4A to D via leads 21.

In the embodiment of Fig. 1, the function of the trace 119 is to ensure eye-safety of the module. As discussed above, the unmodified optical output of a VCSEL may be sufficient to cause injury if incident of a human eye or skin. It is therefore important that a user is alerted to any conditions or damage which may compromise the function of the optical module resulting in a change in the optical output. In this embodiment, this is achieved by monitoring of the capacitance of the trace 119. When the glass breaks, or moisture is present on the MLA glass, both which could compromise the eye safety of the package, the signal from the trace will alter. Thus, any alteration in the signal from the trace may indicate that the module is no longer eye-safe and that use should cease.

In an embodiment, the electrically conductive trace 119 forms part of an electrical circuit that is coupled to a current driver controller or other electronic control unit (ECU) which controls power to the VCSEL 107, as discussed above. In this embodiment, the controller is operable to monitor an electrical characteristic (e.g., electrical continuity; or capacitance, as appropriate) of the trace 119 such that if the monitored characteristic changes by more than a predetermined amount, the controller regulates the optical output of the VCSEL or other light source according to embodiments. In an embodiment, the controller is operable to monitor the electrical characteristic of the trace such that if the monitored characteristic changes by more than a respective predetermined amount, the controller causes the optical output produced by the light source to be stopped. For example, the driver can turn off the VCSEL 107 so that it no longer emits light.

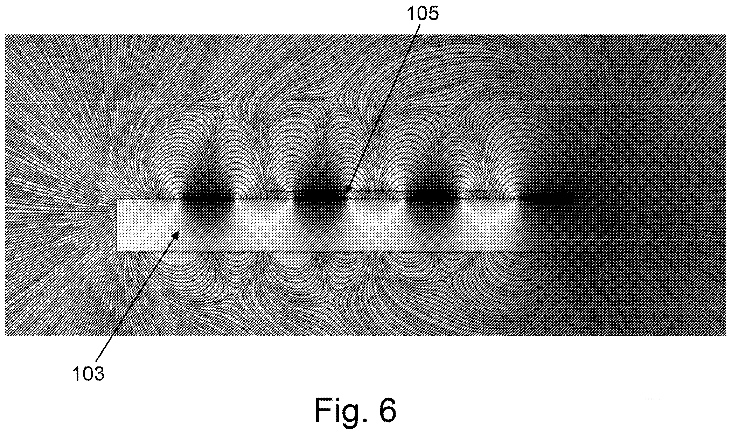

In order to enable changes in the capacitance of the trace to be detected and therefore eye safety of the module to be ensured, it is important that the nominal capacitance of the trace is well understood. However, the quantity of conductive adhesive present on the MLA glass will affect the capacitance of the trace 119. This is shown in Figures 5 and 6, as will now be explained in detail.

Figure 5 shows an example of the 2D electric generated by the capacitive trace 119 on the glass 103 shown in Fig. 2 without either a metal sheet or any glue present. A diagonal cross section of the glass is shown with the MLA visible on the upper surface. The trace is not visible in this figure, however, the shading indicates the electric field emanating from the trace 119. As can be seen from Fig. 6, the electric field oscillates regularly across the surface of the glass as the two terminals of the trace alternate across the diagonal of the glass. In this example, the nominal ITO-C capacitance of the trace is 1.5293pF.

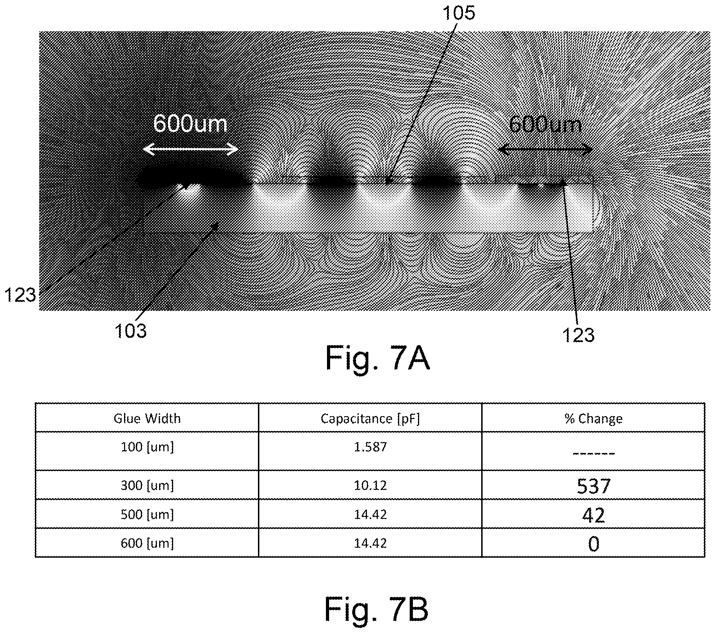

Figure 6A shows the change in capacitance as a conductive strips of a glue layer are added on either side of the glass, as shown in, for example Fig. 4A-4D. Fig. 7A shows a layer of conductive adhesive 123 with 600 µ*m* width present. This is approximately 21% of the width of the glass 103 (in one embodiment the glass is 2800 µ*m* wide and 2760 µ*m* long, with the MLA having overall dimensions of 1600 µ*m ×* 600µ*m*) or 37.5% of the dimensions of the MLA. From comparison of Fig. 6 and 7A, it is clear that there is a large change in the 2D electric field caused by the presence of the conductive adhesive 123.

This change is quantified in Fig. 7B which shows the percentage change in the capacitance of the trace 119 as the width of the layer conductive adhesive is altered. The percentage change shown in the third column of the table is the change in capacitance relative to that shown in the row above. As can be seen from this table, capacitance varies greatly with the width of the conductive adhesive. A change from 100 µ*m* of adhesive to 300 µ*m* of adhesive results in more than a five-fold increase in the capacitance of the trace.

Thus, dispensing of conductive adhesive in the vicinity of a capacitive ITO trace leads to a significant increase in the system capacitance. The latter is due to the interaction between the ITO and glue potentials which create additional, unwanted parallel capacitors. Because it is difficult to control the width of the application of the conductive adhesive on such small scales, it is therefore difficult to quantify accurately the effect on the capacitance of the glue layer. As a result the overall system capacitance may largely vary from one sample to another. Because the eye safety system described above relies on monitoring changes in the capacitance of the trace on the MLA glass, it is important that the capacitance of the trace is well understood for effective functioning of the eye-safety features according to an embodiment.

In an embodiment, a shielding layer of metal 125 is provided on the MLA glass between at least a portion of the electrically conductive trace 119 and the conductive adhesive 123 in order to mitigate the above described problem. Such an arrangement is shown in Fig. 4 which shows a cross section of a portion of the glass 103 according to an embodiment.

In the arrangement of Fig. 4, the shielding layer of metal 125 is embedded within the insulating layer 301 between the terminals of the trace 119 and the layer of conductive adhesive 123. In an embodiment, the shielding metal comprises ITO and is therefore transparent. In such embodiments the metal can at least partially overlap the footprint of the optical beam emitted by the VCSEL without impacting the optical performance of the module 101. In other embodiments, other suitable transparent or non-transparent metals may be employed. In the case of a non-transparent metal, the metal layer preferably does not overlap the footprint of the optical beam emitted by the VCSEL 107. In an embodiment, the shielding layer is provided across the whole of the length of the diffuser. In another embodiment, the shielding layer is provided in the region of the glass 103 to which the conductive adhesive is applied. In the embodiments described above, the metallic shielding layer is provided at opposite edges of the MLA glass 103.

In one embodiment the structure shown in Fig. 4 is created by placing an initial SiO2 layer on the glass. Then the ITO traces are deposited on this initial layer and covered by another SiO2 protection layer. Several further ITO shielding layers and SiO2 protection layers may further be added in this fashion.

Because the metal layer embedded in the insulating layer of SiO₂, or other layer of other insulating material according to embodiments, the metal sheet is floating, i.e. it is not electrically connected to any other components in the module. In other embodiments, the metal sheet may be grounded.

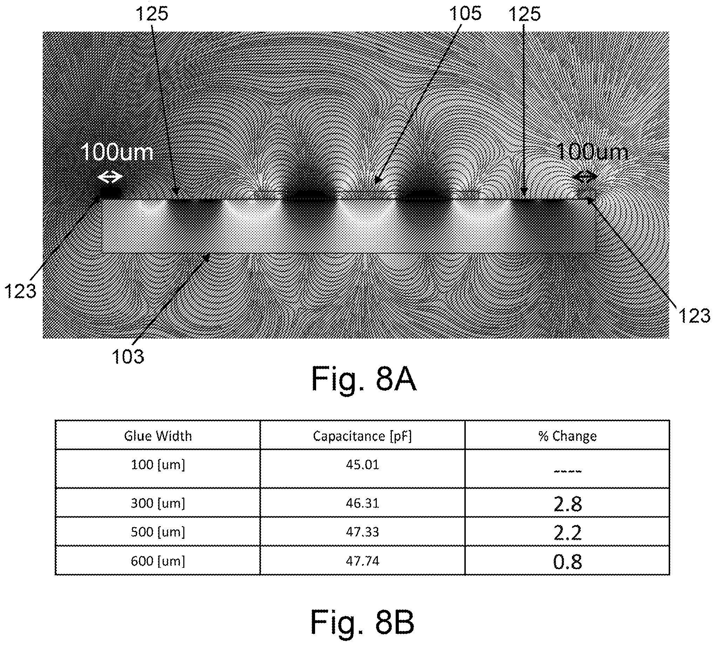

The shielding layer of metal, provided in addition to the metallic trace 119, is provided in order to disrupt the electric field lines emanating from the adhesive, such that they do not interact with the sensing ITO trace 119. This effect is shown in Fig. 8A and 8B. In this example, a 3000 µ*m* long and 700 µ*m* wide metal layer 125 is present on either side of the glass 103. Although the metal layer itself is not visible in Figure 8A, its position is indicated by the reference numerals 125. The 2D electric field generated by the capacitive trace is shown in Figure 8A for a glue width of 100 µ*m* As can be seen for this figure, the electric field of the trace is shielded above the entire area where the metal sheet is present. This will therefore remain largely unaffected by the presence of glue in this area of the glass. The electric field will therefore be largely invariant to the width of the glue.

The table in Figure 8B shows the percentage change in capacitance as the width of the glue changes. While the nominal capacitance is much higher with the metal layer 125 present, the percentage change as a function of glue width is much smaller than arrangements in which the metal layer not present. For example, the percentage change in capacitance on going from a glue width of 100 µ*m* of glue to 300 µ*m* of glue results in a change in capacitance of only 2.8% compared with 537% without the shielding metal layer. Thus, the effect of the width of the applied adhesive on the capacitance of the trace can be largely mitigated by the presence of the metal shielding layer, thereby enabling much more precise control of the capacitance of the trace. This enables a greater tolerance to variations in the width of glue applied, facilitating manufacturing.

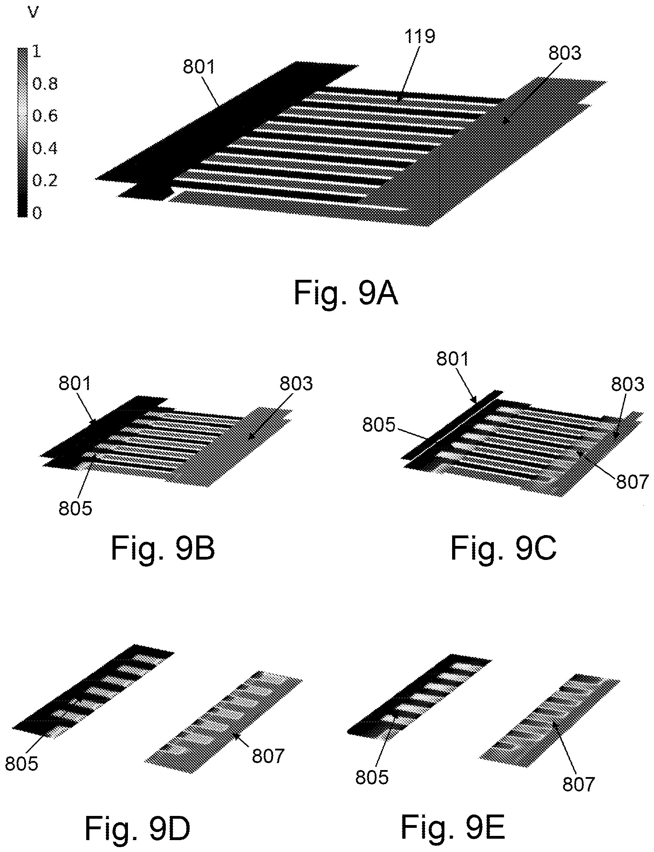

The shielding effect of the metal layer on the electric field is further demonstrated in Fig. 9A-9E. Fig. 9A is an exploded schematic view of the electric potentials arising from ITO trace and conductive adhesive with no shielding layer present. Although not visible in this figure, the potential of the trace will be affected beneath the areas of glue 801 and 803 and therefore dependent on the width of the glue 801 and 803.

Figs. 9B and 9C in contrast show the potential of the trace with 600µm width and 200µm width of glue when the metal plate is present. Figs. 9D and 9E show the potential of the trace directly above the metal layer. As can be seen in both figures, the electric field is shielded by the metal plate. Although there is a slight difference between electric field between the 100µm and 300µm glue width cases, the electric field is largely unchanged due to the presence of the metal shielding layer.

As shown above, the double layer ITO arrangement according to embodiments enables eye safety of an illuminator or other module to be ensured, with little to no impact on the optical performance of the module.

Embodiments of the present disclosure can be employed in many different applications including providing illumination for facial recognition sensors, for example, in smartphones and other technologies or time of flight sensors that find use in the automotive industry, amongst others.

List of reference numerals:
101: optoelectronic module
103: MLA glass
105: optical component
107: light source
109: leadframe
111: spacer
113: cavity
115: socket
117: surface
119: trace
121: leads
123: conductive adhesive
125: metal layer
201: electrical contacts
301: insulating layer
401: capacitor terminals
403: conductive glue
405: terminal
407: conductive glue
801: Areas of glue
803: Areas of glue
805 and 807 metal layer

The skilled person will understand that in the preceding description and appended claims, positional terms such as `above', 'along', 'side', etc. are made with reference to conceptual illustrations, such as those shown in the appended drawings. These terms are used for ease of reference but are not intended to be of limiting nature. These terms are therefore to be understood as referring to an object when in an orientation as shown in the accompanying drawings.

## Claims

1. An optical assembly, the optical assembly comprising:
an interdigital capacitor consisting of
an electrically conductive trace (119);
one or more electrical contacts (201) in electrical connection with the conductive trace (119); and
an insulating layer (301) covering at least a portion of the interdigital capacitor,
wherein the one or more electrical contacts (201) and a portion of the insulating layer (301) are configured to receive conductive adhesive (123) suitable for providing electrical connection to the one or more electrical contacts (201), and
wherein
the optical assembly further comprises a metallic shielding layer (125) positioned between the conductive trace (119) and the portion of the insulating layer (301) configured to receive the conductive adhesive (123).

2. The optical assembly of claim 1, further comprising circuitry configured to detect a change in capacitance of the interdigital capacitor.

3. The optical assembly of claim 1 or 2, wherein the conductive trace (119) comprises indium titanium oxide.

4. The optical assembly of one of the previous claims, wherein the metallic layer (125) is transparent.

5. The optical assembly of claim 4, wherein the metallic layer (125) comprises indium titanium oxide.

6. The optical assembly of one of the previous claims, wherein the metallic layer (125) is embedded in the insulating layer (301).

7. The optical assembly of one of the previous claims, wherein the metallic layer (125) is floating.

8. The optical assembly of one of the previous claims, wherein the metallic layer (125) is adjacent to one or more edges of the optical assembly.

9. An optical module (1) comprising:
an optical assembly, according to claim 1, the optical assembly comprising
the interdigital capacitor with an electrically conductive trace (119),
one or more electrical contacts (201) in electrical connection with the conductive trace (119), and the
insulating layer (301) covering at least a portion of the interdigital capacitor;
circuitry operable to detect a change in capacitance of the interdigital capacitor; and
conductive adhesive (123) disposed on at least a portion of the one or more electrical contacts (201) and a portion of the insulating layer (301) and configured to maintain the circuitry and one or more electrical contacts (201) in electrical connection,
wherein the optical assembly further comprises the metallic layer (125) positioned between the conductive trace (119) and the portion of the insulating layer (301) on which the conductive adhesive (123) is disposed.

10. The optical module of claim 9, wherein the conductive trace (119) comprises indium titanium oxide.

11. The optical module of claim 9 or 10, wherein the metallic layer (125) is transparent.

12. The optical module of claim 11, wherein the metallic layer (125) comprises indium titanium oxide.

13. The optical module of one of claims 9 to 12, wherein the metallic layer (125) is embedded in the insulating layer.

14. The optical module of one of claims 9 to 13, wherein the metallic layer (125) is floating.

15. The optical assembly of one of claims 9 to 14, wherein the metallic layer (125) is adjacent to one or more edges of the optical assembly.

## Patentansprüche

1. Optikbaugruppe, wobei die Optikbaugruppe Folgendes umfasst:
einen Interdigitalkondensator, bestehend aus einer elektrisch leitenden Spur (119);
einen oder mehrere elektrische Kontakte (201) in elektrischer Verbindung mit der leitenden Spur (119); und
eine Isolierschicht (301), die zumindest einen Anteil des Interdigitalkondensators bedeckt,
wobei der eine oder die mehreren elektrischen Kontakte (201) und ein Anteil der Isolierschicht (301) ausgelegt sind zum Aufnehmen von leitendem Klebemittel (123), das geeignet ist zum Liefern einer elektrischen Verbindung mit dem einen oder den mehreren elektrischen Kontakten (201), und
wobei
die Optikbaugruppe ferner eine metallische Abschirmschicht (125), positioniert zwischen der leitenden Spur (119) und dem Anteil der Isolierschicht (301), ausgelegt zum Aufnehmen des leitenden Klebemittels (123), umfasst.

2. Optikbaugruppe nach Anspruch 1, ferner umfassend eine Schaltungsanordnung, die ausgelegt ist zum Detektieren einer Kapazitätsänderung des Interdigitalkondensators.

3. Optikbaugruppe nach Anspruch 1 oder 2, wobei die leitende Spur (119) Indiumtitanoxid umfasst.

4. Optikbaugruppe nach einem der vorhergehenden Ansprüche, wobei die metallische Schicht (125) transparent ist.

5. Optikbaugruppe nach Anspruch 4, wobei die metallische Schicht (125) Indiumtitanoxid umfasst.

6. Optikbaugruppe nach einem der vorhergehenden Ansprüche, wobei die metallische Schicht (125) in die Isolierschicht (301) eingebettet ist.

7. Optikbaugruppe nach einem der vorhergehenden Ansprüche, wobei die metallische Schicht (125) potentialfrei ist.

8. Optikbaugruppe nach einem der vorhergehenden Ansprüche, wobei die metallische Schicht (125) an einen oder mehrere Ränder der Optikbaugruppe angrenzt.

9. Optikmodul (1) umfassend:
eine Optikbaugruppe nach Anspruch 1, wobei die Optikbaugruppe Folgendes umfasst:
den Interdigitalkondensator mit einer elektrisch leitenden Spur (119),
einen oder mehrere elektrische Kontakte (201) in elektrischer Verbindung mit der leitenden Spur (119), und
die Isolierschicht (301), die zumindest einen Anteil des Interdigitalkondensators bedeckt;
eine Schaltungsanordnung, die betreibbar ist zum Detektieren einer Kapazitätsänderung des Interdigitalkondensators;
und
leitendes Klebemittel (123), aufgebracht auf mindestens einem Anteil des einen oder der mehreren elektrischen Kontakte (201) und einem Anteil der Isolierschicht (301) und ausgelegt zum Halten der Schaltungsanordnung und eines oder mehrerer elektrischer Kontakte (201) in elektrischer Verbindung,
wobei die Optikbaugruppe ferner die metallische Abschirmschicht (125), positioniert zwischen der leitenden Spur (119) und dem Anteil der Isolierschicht (301), auf dem das leitende Klebemittel (123) aufgebracht ist, umfasst.

10. Optikmodul nach Anspruch 9, wobei die leitende Spur (119) Indiumtitanoxid umfasst.

11. Optikmodul nach Anspruch 9 oder 10, wobei die metallische Schicht (125) transparent ist.

12. Optikmodul nach Anspruch 11, wobei die metallische Schicht (125) Indiumtitanoxid umfasst.

13. Optikmodul nach einem der Ansprüche 9 bis 12, wobei die metallische Schicht (125) in die Isolierschicht eingebettet ist.

14. Optikmodul nach einem der Ansprüche 9 bis 13, wobei die metallische Schicht (125) potentialfrei ist.

15. Optikbaugruppe nach einem der Ansprüche 9 bis 14, wobei die metallische Schicht (125) an einen oder mehrere Ränder der Optikbaugruppe angrenzt.

## Revendications

1. Ensemble optique, l'ensemble optique comprenant :
un condensateur interdigité constitué d'un tracé électroconducteur (119) ;
un ou plusieurs contacts électriques (201) en connexion électrique avec le tracé électroconducteur (119) ; et
une couche isolante (301) recouvrant au moins une partie du condensateur interdigité,
dans lequel les un ou plusieurs contacts électriques (201) et une partie de la couche isolante (301) sont configurés pour recevoir un adhésif conducteur (123) adapté pour fournir une connexion électrique aux un ou plusieurs contacts électriques (201), et
dans lequel
l'ensemble optique comprend en outre une couche de blindage métallique (125) positionnée entre le tracé conducteur (119) et la partie de la couche isolante (301) configurée pour recevoir l'adhésif conducteur (123).

2. Ensemble optique selon la revendication 1, comprenant en outre un montage de circuits configuré pour détecter un changement de capacité du condensateur interdigité.

3. Ensemble optique selon la revendication 1 ou 2, dans lequel le tracé conducteur (119) comprend de l'oxyde d'indium et de titane.

4. Ensemble optique selon l'une des revendications précédentes, dans lequel la couche métallique (125) est transparente.

5. Ensemble optique selon la revendication 4, dans lequel la couche métallique (125) comprend de l'oxyde d'indium et de titane.

6. Ensemble optique selon l'une des revendications précédentes, dans lequel la couche métallique (125) est noyée dans la couche isolante (301).

7. Ensemble optique selon l'une des revendications précédentes, dans lequel la couche métallique (125) est flottante.

8. Ensemble optique selon l'une des revendications précédentes, dans lequel la couche métallique (125) est adjacente à un ou plusieurs bords de l'ensemble optique.

9. Module optique (1) comprenant :
un ensemble optique, selon la revendication 1, l'ensemble optique comprenant :
le condensateur interdigité avec un tracé électroconducteur (119),
un ou plusieurs contacts électriques (201) en connexion électrique avec le tracé électroconducteur (119), et
la couche isolante (301) recouvrant au moins une partie du condensateur interdigité ;
un montage de circuits permettant de détecter un changement de capacité du condensateur interdigité ; et
un adhésif conducteur (123) disposé sur au moins une partie des un ou plusieurs contacts électriques (201) et une partie de la couche isolante (301) et configuré pour maintenir le montage de circuits et un ou plusieurs contacts électriques (201) en connexion électrique,
dans lequel l'ensemble optique comprend en outre la couche métallique (125) positionnée entre le tracé conducteur (119) et la partie de la couche isolante (301) sur laquelle est disposé l'adhésif conducteur (123).

10. Module optique selon la revendication 9, dans lequel le tracé conducteur (119) comprend de l'oxyde d'indium et de titane.

11. Module optique selon la revendication 9 ou 10, dans lequel la couche métallique (125) est transparente.

12. Module optique selon la revendication 11, dans lequel la couche métallique (125) comprend de l'oxyde d'indium et de titane.

13. Module optique selon l'une des revendications 9 à 12, dans lequel la couche métallique (125) est noyée dans la couche isolante.

14. Module optique selon l'une des revendications 9 à 13, dans lequel la couche métallique (125) est flottante.

15. Ensemble optique selon l'une des revendications 9 à 14, dans lequel la couche métallique (125) est adjacente à un ou plusieurs bords de l'ensemble optique.
